# EUROPEAN PATENT APPLICATION

(11) **EP 4 800 344 A1**
(43) Date of publication of application: **02.09.2026**
(21) Application number: 26190960.0
(22) Date of filing: 31.01.2025
(51) Int. Cl.: F28D 15/04, F28D 15/02, H10W 40/73

(54) **VAPOR CHAMBER**

(30) Priority: 01.02.2024 CN 202410148782
(62) Document number(s) of the earlier application(s) in accordance with Art. 76 EPC: 25155204.8 / 4 600 596
(71) Applicant: Purple Cloud Development Pte. Ltd., Singapore 128424 (SG)
(72) Inventor: Wang, Xue Mei, Hui Zhou City (CN)
(74) Representative: Grünecker Patent- und Rechtsanwälte PartG mbB

(57) **Abstract**

A vapor chamber may include a first plate, an evaporator wick structure, a second plate, a condenser wick structure, and a core condenser wick structure. The first plate includes a first surface, a first plate perimeter ledge, a plurality of first support structures, and a plurality of second support structures. The plurality of first support structures and the plurality of second support structures are coupled to and extend from the first surface. The first plate perimeter ledge surrounds the first surface. The evaporator wick structure includes a first surface wick portion and first support wick portion. The first surface wick portion is disposed on the first surface and the first support wick portion is disposed on the plurality of first support structures. The second plate includes a second surface and second plate perimeter portion. The second plate perimeter portion surrounds the second surface and is coupled to the first plate perimeter ledge. The first plate and the second plate define an interior cavity. The interior cavity includes a first portion, a second portion, and a third portion. The condenser wick structure is disposed on the second surface. The core condenser wick structure is coupled to and extends from the condenser wick structure. The core condenser wick structure disposed in the first portion.

## Description

### TECHNICAL FIELD

The present disclosure is related to thermal management of electronic systems in general and more particularly but not limited to vapor chambers.

### BACKGROUND OF THE INVENTION

With the increase of the processing speed and performance of electronic components, such as application-specific integrated circuits (ASICs) and central processing units (CPU), the amount of heat generated during operation of the electronic component increases. The heat generation increases the temperature of the electronic component and, if the heat cannot be dissipated effectively, reliability and performance of the electronic component are reduced.

To prevent overheating of an electronic component of a thin and compact electronic device, a vapor chamber may be used. The generated heat of the electronic component is conducted through a limited area of the electronic component to a larger area of the vapor chamber, and the generated heat can be inefficiently distributed along the vapor chamber. Consequently, the vapor chamber may not adequately cool the electronic component, potentially causing the electronic component to overheat.

### SUMMARY OF THE INVENTION

The present disclosure provides a vapor chamber having condensate transport structures, speeding up transport of working fluid back to a heat source.

The invention is as defined in the appended claims. In some aspects, the techniques described herein relate to a vapor chamber, including a first plate, an evaporator wick structure, a second plate, and a condenser wick structure. The first plate includes a first surface, a first plate perimeter ledge, a plurality of first support structures, and a plurality of second support structures. The plurality of first support structures and the plurality of second support structures, both, respectively coupled to and extend from the first surface. The first plate perimeter ledge surrounds the first surface. The evaporator wick structure includes a first surface wick portion and a first support wick portion. The first surface wick portion is disposed on the first surface and the first support wick portion is disposed on the plurality of first support structures. The second plate includes a second surface and a second plate perimeter portion. The second plate perimeter portion surrounds the second surface and is coupled to the first plate perimeter ledge. The condenser wick structure is disposed on the second surface.

In some aspects, the techniques described herein relate to a vapor chamber, wherein the first plate and the second plate define an interior cavity. The interior cavity includes, a first portion, a second portion, and a third portion. The first portion includes a first depth, second perimeter edge and a third perimeter edge. The second portion includes a second depth, and the third portion includes a third depth. The third perimeter edge is opposite the second perimeter edge. The second portion extends in a second direction from the second perimeter edge and the third portion extends in a third direction from the third perimeter edge. The first depth and the second depth and the third depth, all, extend from the first surface to the second surface. The second depth equals to the third depth. The first depth is greater than the second depth and the third depth.

In some aspects, the techniques described herein relate to a vapor chamber, wherein each plurality of first support structures respectively includes a first diameter, and wherein each plurality of second support structures respectively includes a second diameter. The first diameter is greater than the second diameter. The plurality of first support structures is disposed in the first portion and the plurality of second support structures is disposed in the second portion and the third portion.

In some aspects, the techniques described herein relate to a vapor chamber, wherein the plurality of second support structures disposed in the second portion include a second amount, and wherein the plurality of second support structures disposed in the third portion include a third amount. The third amount is greater than the second amount.

In some aspects, the techniques described herein relate to a vapor chamber, wherein the second plate includes a plurality of condensate transport structures. The plurality of condensate transport structures is coupled to and extends from the second surface. The condenser wick structure is disposed on the plurality of condensate transport structures. Each plurality of condensate transport structures respectively includes a condensate structure length, and each plurality of condensate transport structures respectively includes a cuboid shape. The condensate structure length includes two or more different lengths.

In some aspects, the techniques described herein relate to a vapor chamber, wherein the plurality of first support structures, the first support wick portion, and the plurality of second support structures respectively abut the condenser wick structure. In some aspects, the techniques described herein relate to a vapor chamber, wherein the plurality of condensate transport structures is disposed in the first portion, in the second portion, and in the third portion.

In some aspects, the techniques described herein relate to a vapor chamber, wherein the plurality of first support structures, the first support wick portion, and the plurality of second support structures respectively abut the second surface, and wherein the first support wick portion abuts the condenser wick structure. In some aspects, the techniques described herein relate to a vapor chamber, wherein the plurality of condensate transport structures is disposed in the first portion.

In some aspects, the techniques described herein relate to a vapor chamber, including a core condenser wick structure. The core condenser wick structure is coupled to and extends from the condenser wick structure. The core condenser wick structure is disposed in the first portion.

In some aspects, the techniques described herein relate to a vapor chamber, wherein the plurality of first support structures and the plurality of second support structures respectively abut the second surface, and wherein the first support wick portion abuts the core condenser wick structure.

In some aspects, the techniques described herein relate to a vapor chamber, including a plurality of heat pipes. Each plurality of heat pipes respectively includes an inner chamber surface, a closed end, an open end, and a pipe wick structure. The open end is opposite the closed end and the inner chamber surface is between the closed end and the open end. The pipe wick structure is disposed on the inner chamber surface. The second plate includes a plurality of through holes. Each plurality of through holes respectively includes a flange and the flange respectively extends from each plurality of through holes opposite the second surface. Each plurality of heat pipes abuts the flange and each plurality of through holes. The open end respectively extends through each plurality of through holes and abuts the evaporator wick structure.

In some aspects, the techniques described herein relate to a vapor chamber, wherein the second plate includes a plurality of condensate transport structures. The plurality of condensate transport structures is coupled to and extends from the second surface. The condenser wick structure is disposed on the plurality of condensate transport structures.

In some aspects, the techniques described herein relate to a vapor chamber, wherein each plurality of condensate transport structures respectively includes a condensate structure length, and each plurality of condensate transport structures respectively includes a cuboid shape. The condensate structure length includes two or more different lengths.

In some aspects, the techniques described herein relate to a vapor chamber, wherein the plurality of first support structures, the first support wick portion, and the plurality of second support structures respectively abut the condenser wick structure. In some aspects, the techniques described herein relate to a vapor chamber, wherein the plurality of condensate transport structures is disposed in the first portion, in the second portion, and in the third portion.

In some aspects, the techniques described herein relate to a vapor chamber, wherein the plurality of first support structures, the first support wick portion, and the plurality of second support structures respectively abut the second surface. The first support wick portion abuts the condenser wick structure. In some aspects, the techniques described herein relate to a vapor chamber, wherein the plurality of condensate transport structures is disposed in the first portion.

In some aspects, the techniques described herein relate to a vapor chamber, further including a core condenser wick structure. The core condenser wick structure is coupled to and extends from the condenser wick structure. The core condenser wick structure is disposed in the first portion.

In some aspects, the techniques described herein relate to a vapor chamber, wherein the plurality of first support structures and the plurality of second support structures respectively abut the second surface. The first support wick portion abuts the core condenser wick structure.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of vapor chambers incorporating aspects of the presently disclosed principles are illustrated by way of example, and not by way of limitation.
Fig. 1 illustrates a vapor chamber according to one embodiment of the present disclosure.
Fig. 2A illustrates a vapor chamber according to an alternative embodiment of the present disclosure.
Fig. 2B is an exploded view of the alternative vapor chamber of Fig. 2A, according to one embodiment of the present disclosure.
Fig. 3A illustrates a vapor chamber according to another alternative embodiment of the present disclosure.
Fig. 3B is an exploded view of the another alternative vapor chamber of Fig. 3A, according to one embodiment of the present disclosure.
Fig. 4A illustrates a vapor chamber according to yet another alternative embodiment of the present disclosure.
Fig. 4B is an exploded view of the yet another alternative vapor chamber of Fig. 4A, according to one embodiment of the present disclosure.
Fig. 5 illustrates a vapor chamber according to an alternative embodiment of the present disclosure
Fig. 6A illustrates a vapor chamber according to another alternative embodiment of the present disclosure.
Fig. 6B is an exploded view of the another alternative vapor chamber of Fig. 6A, according to one embodiment of the present disclosure.
Fig. 7A illustrates a vapor chamber according to yet another alternative embodiment of the present disclosure.
Fig. 7B is an exploded view of the yet another alternative vapor chamber of Fig. 7A, according to one embodiment of the present disclosure.
Fig. 8A illustrates a vapor chamber according to further yet another alternative embodiment of the present disclosure.
Fig. 8B is an exploded view of the further yet another alternative vapor chamber of Fig. 8A, according to one embodiment of the present disclosure.

### DETAILED DESCRIPTION

The following describes various principles related to vapor chambers by way of reference to specific examples of second plates coupled to first plates, including specific arrangements and examples of wick structures embodying innovative concepts. More particularly, but not exclusively, such innovative principles are described in relation to selected examples of evaporator wick structures and condenser wick structures, and their dispositions within the vapor chambers, and well-known functions or constructions are not described in detail for purposes of succinctness and clarity. Nonetheless, the disclosed principles can be incorporated in various other embodiments of different evaporator wick structures and condenser wick structures, and their dispositions within the vapor chambers to achieve any of a variety of desired outcomes, characteristics, and/or performance criteria.

Thus, evaporator wick structures and condenser wick structures, and their dispositions within the vapor chambers having attributes that are different from those specific examples discussed herein can embody of the innovative principles, and can be used in applications not described herein in detail. Accordingly, embodiments of evaporator wick structures and condenser wick structures, and their dispositions within the vapor chambers not described herein in detail also fall within the scope of this disclosure, as will be appreciated by those of ordinary skill in the relevant art following a review of this disclosure.

Example embodiments as disclosed herein are directed to vapor chambers, wherein a surface of the vapor chamber is thermally coupled to an electronic component, transporting heat away therefrom, and to working fluid inside of the vapor chamber. In response to receiving the heat, a portion of the working fluid transitions from a liquid phase to a gas phase. The gas portion of the working fluid rises and distributes the received heat substantially along the second plate of the vapor chamber. The second plate transfers the heat to ambient air outside of the vapor chamber. The working fluid condenses back into a liquid in response to conducting the heat to the second plate and the liquid returns to a center of the vapor chamber where the cycle is repeated.

The vapor chambers may be configured within an electric or electronics system that includes heat producing electronic components to be cooled.

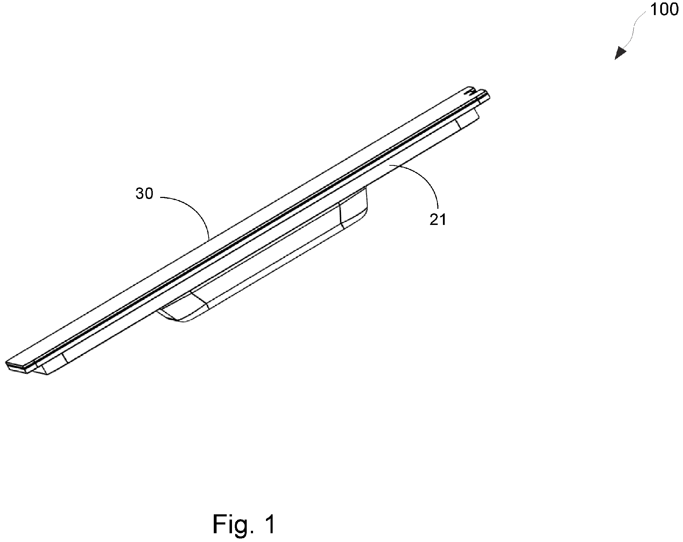

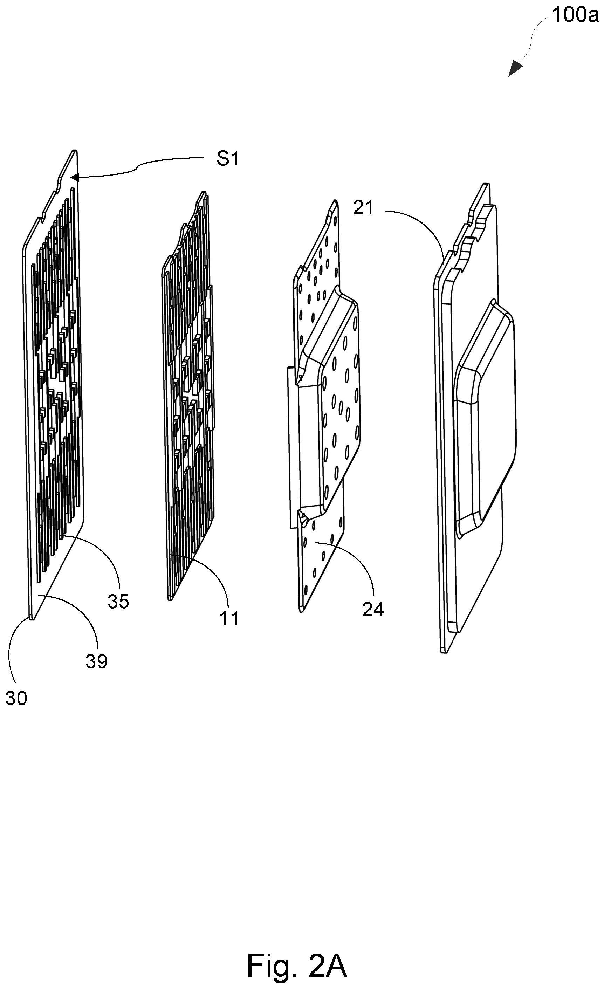

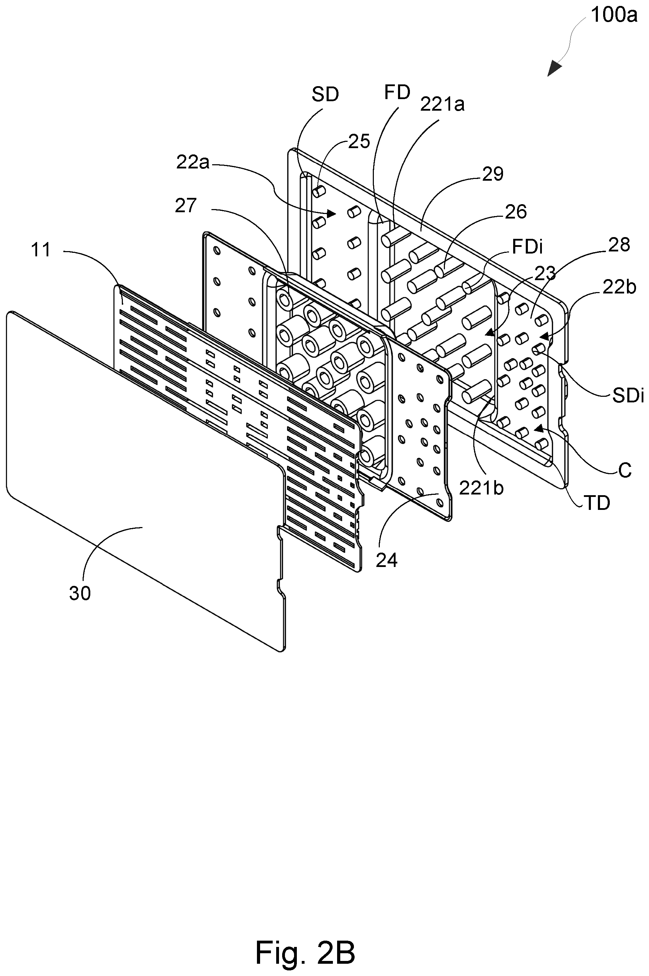

Fig. 1 includes at least an embodiment of a vapor chamber 100 and Figs. 2A and 2B include at least an alternative embodiment of the vapor chamber 100 of Fig. 1. The alternative vapor chamber 100a of Figs. 2A and 2B may be similar in some respects to the vapor chamber 100 of Fig. 1, and therefore may be best understood with reference thereto where like numerals designate like components not described again in detail. The vapor chamber 100a includes a first plate 21, an evaporator wick structure 24 and 27, a second plate 30, and a condenser wick structure 11. The first plate 21 includes a first surface 28, a first plate perimeter ledge 29, a plurality of first support structures 26, and a plurality of second support structures 25. The plurality of first support structures 26 and the plurality of second support structures 25, both, respectively coupled to and extend from the first surface 28. The first plate perimeter ledge 29 surrounds the first surface 28. The evaporator wick structure 24 and 27 includes a first surface wick portion 24 and a first support wick portion 27. The first surface wick portion 24 is disposed on the first surface 28 and the first support wick portion 27 is disposed on the plurality of first support structures 26. The second plate 30 includes a second surface S1 and a second plate perimeter portion 39. The second plate perimeter portion 39 surrounds the second surface S1 and is coupled to the first plate perimeter ledge 29. The condenser wick structure 11 is disposed on the second surface S1. In some embodiments, the evaporator wick structure 24 and 27 and the condenser wick structure 11, each, respectively include at least one of a sintered metal powder wick, a metal mesh wick, and a sintered ceramic powder wick, and any of the foregoing combinations. In some embodiments, the first support wick portion 27 includes a sintered powder wick formed by a sintering process. In some embodiments, the sintered powder wick can be formed using multiple sintering processes.

In some embodiments, the first plate 21 and the second plate 30 define an interior cavity C. The interior cavity C includes, a first portion 23, a second portion 22a, and a third portion 22b. The first portion 23 includes a first depth FD, second perimeter edge 221a and a third perimeter edge 221b. The second portion 22a includes a second depth SD, and the third portion 22b includes a third depth TD. The third perimeter edge 221b is opposite the second perimeter edge 221a. The second portion 22a extends in a second direction from the second perimeter edge 221a and the third portion 22b extends in a third direction from the third perimeter edge 221b. The first depth FD and the second depth SD and the third depth TD, all, extend from the first surface 28 to the second surface S1. The second depth SD equals to the third depth TD. The first depth FD is greater than the second depth SD and the third depth TD.

In some embodiments, each plurality of first support structures 26 respectively includes a first diameter FDi, and wherein each plurality of second support structures 25 respectively includes a second diameter SDi. The first diameter FDi is greater than the second diameter SDi. The plurality of first support structures 26 is disposed in the first portion 23 and the plurality of second support structures 25 is disposed in the second portion 22a and the third portion 22b.

In some embodiments, the plurality of second support structures 25 disposed in the second portion 22a include a second amount, and the plurality of second support structures 25 disposed in the third portion 22b include a third amount. The third amount is greater than the second amount. Thus, the vapor area in the second portion 22a is greater than the vapor area in the third portion 22b, and the surface area in the third portion 22b is greater than the surface area in the second portion 22a. As a result, a capillary pumping action is formed, driving vapor to flow from the first portion 23 and the second portion 22a for condensation, and working fluid to flow from the second surface S1 and condenser wick structure 11 to the first support wick portion 27 and the evaporator wick structure 24 and the third portion 22b back to the first surface 28 and first portion 23.

In some embodiments, the second plate 30 includes a plurality of condensate transport structures 35. The plurality of condensate transport structures 35 is coupled to and extends from the second surface S1. The condenser wick structure 11 is disposed on the plurality of condensate transport structures 35. Each plurality of condensate transport structures 35 respectively includes a condensate structure length, and each plurality of condensate transport structures 35 respectively includes a cuboid shape. The condensate structure length includes two or more different lengths. In some embodiments, the plurality of condensate transport structures 35 is disposed along a length of the vapor chamber 100a from the third portion 22b, the first portion 23, and the second portion 22a in rows. In some embodiments, more than one of each plurality of condensate transport structures 35 is disposed in one or more rows. In some embodiments, the condensate structure length includes one length.

In some embodiments, the plurality of first support structures 26, the first support wick portion 27, and the plurality of second support structures 25 respectively abut the condenser wick structure 11. In some embodiments, the plurality of condensate transport structures 35 is disposed in the first portion 23, in the second portion 22a, and in the third portion 22b. In some embodiments, each plurality of condensate transport structures 35 includes two or more different heights. In some embodiments, a height of the plurality of condensate transport structures 35 disposed in the first portion 23 is greater than a height of the plurality of condensate transport structure disposed in the second portion 22a, and in the third portion 22b. In some embodiments, each plurality of condensate transport structures 35 includes one height.

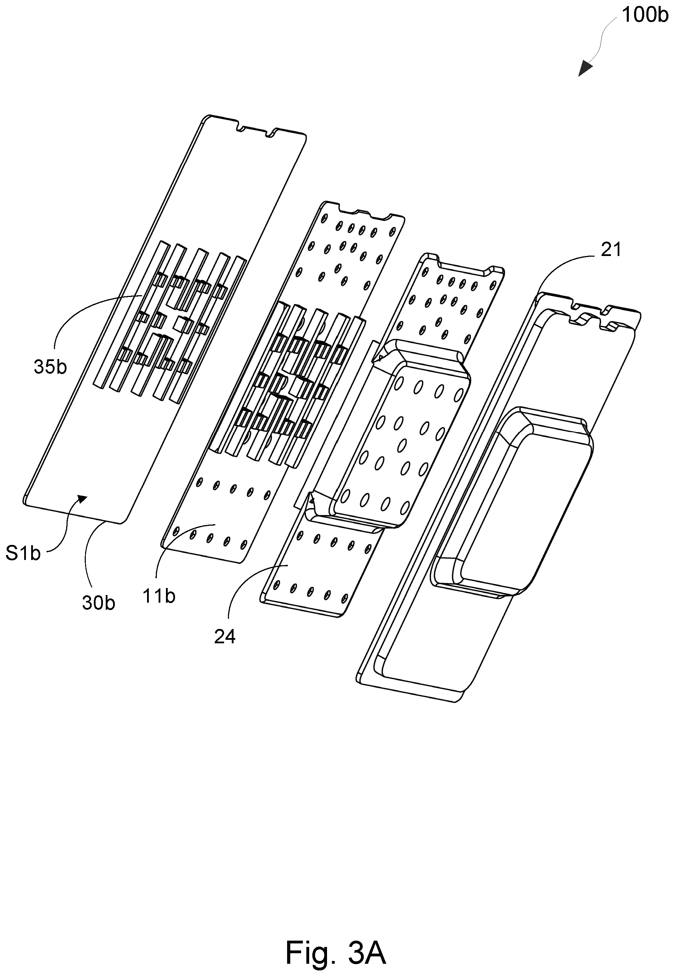

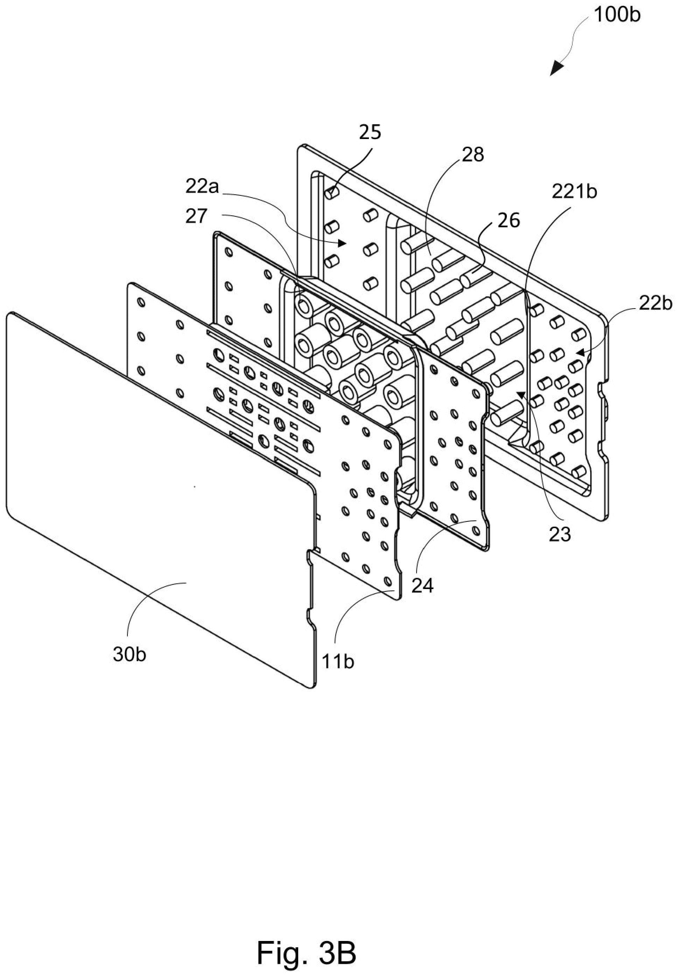

Figs. 3A and 3B include at least another alternative embodiment of the vapor chamber 100 of Fig. 1. The another alternative vapor chamber 100b of Figs. 3A and 3B may be similar in some respects to the vapor chamber 100/100a of Figs. 1, 2A, and 2B, and therefore may be best understood with reference thereto where like numerals designate like components not described again in detail. The difference between the another alternative vapor chamber 100b of Figs. 3A and 3B and the vapor chambers 100/100a of Figs. 1, 2A, and 2B is the second plate 30b, the condenser wick structure 11b, and the condensate transport structures 35b. The first support wick portion 27, and the plurality of second support structures 25 respectively abut the second surface S1b. The first support wick portion 27 abuts the condenser wick structure 11b. In some embodiments, the plurality of condensate transport structures 35b is disposed in the first portion 23.

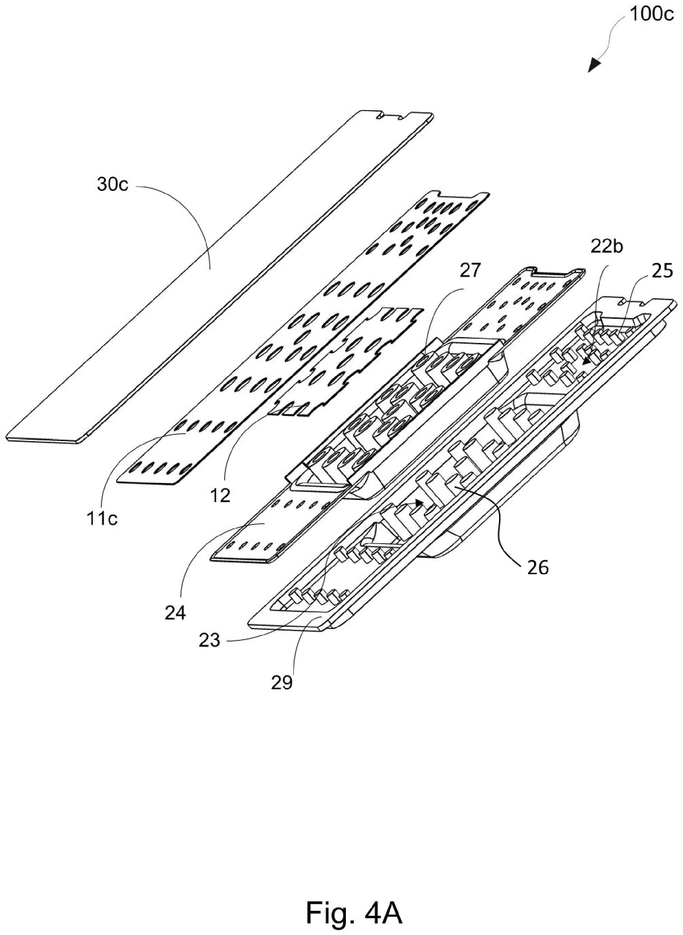

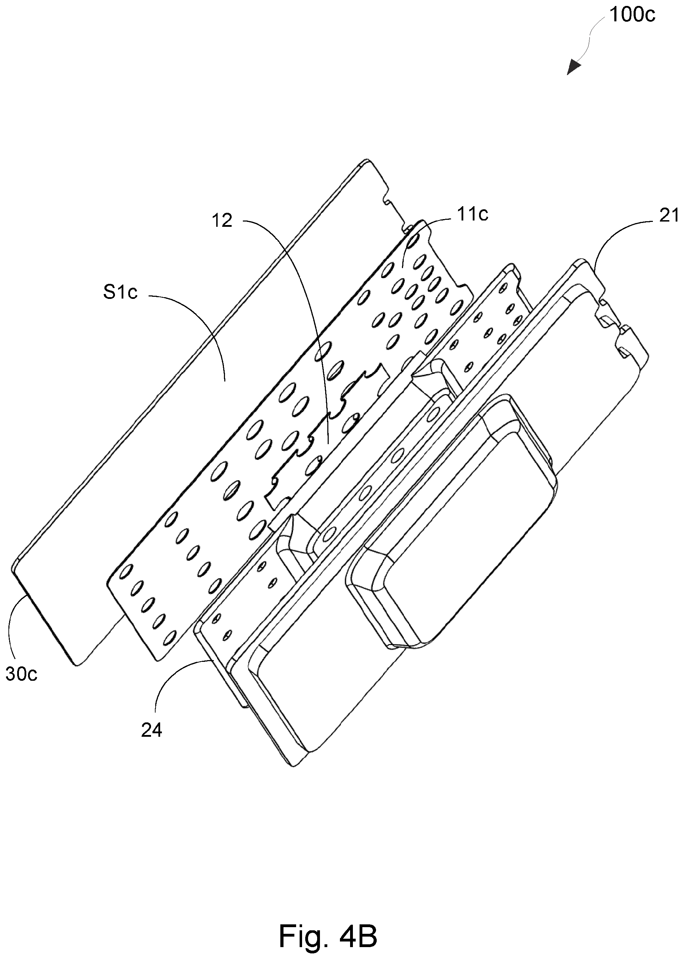

Figs. 4A and 4B include at least yet another alternative embodiment of the vapor chamber 100 of Fig. 1. The yet another alternative vapor chamber 100c of Figs. 4A and 4B may be similar in some respects to the vapor chambers 100/100a of Figs. 1, 2A, and 2B, and therefore may be best understood with reference thereto where like numerals designate like components not described again in detail. The difference between the yet another alternative vapor chamber 100c of Figs. 4A and 4B and the vapor chambers 100/100a of Figs. 1, 2A, and 2B is the second plate 30c, the condenser wick structure 11c, the elimination of the condensate transport structures 35, and the addition of the core condenser wick structure 12. The core condenser wick structure 12 is coupled to and extends from the condenser wick structure 11c. The core condenser wick structure 12 is disposed in the first portion 23. In some embodiments, the plurality of first support structures 26 and the plurality of second support structures 25 respectively abut the second surface S1c. The first support wick portion 27 abuts the core condenser wick structure 12. In some embodiments, the core condenser wick structure 12 includes at least one of a sintered metal powder wick, a metal mesh wick, and a sintered ceramic powder wick. In some embodiments, the sintered powder wick can be formed using multiple sintering processes.

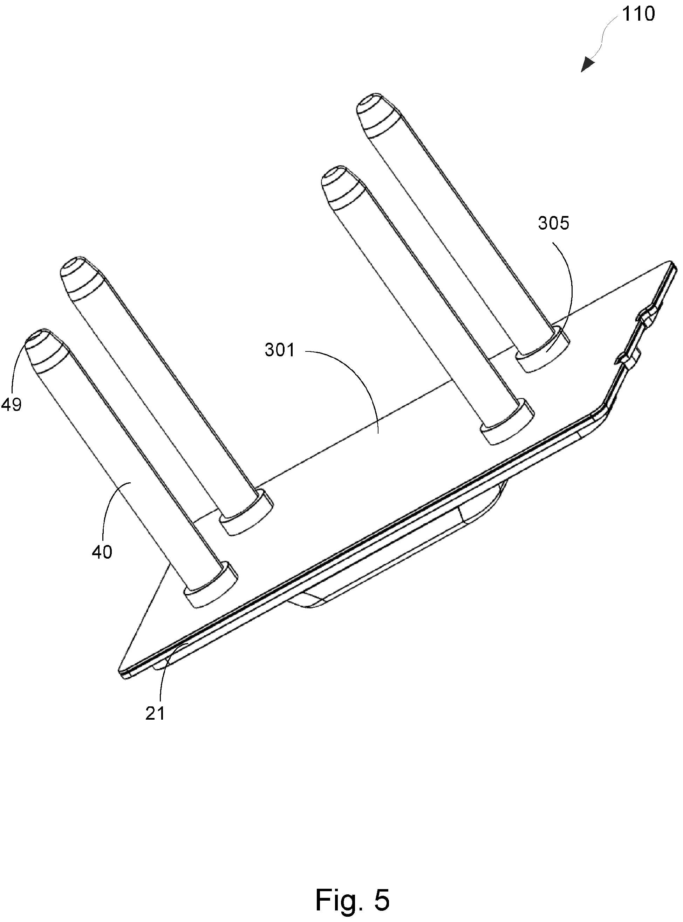

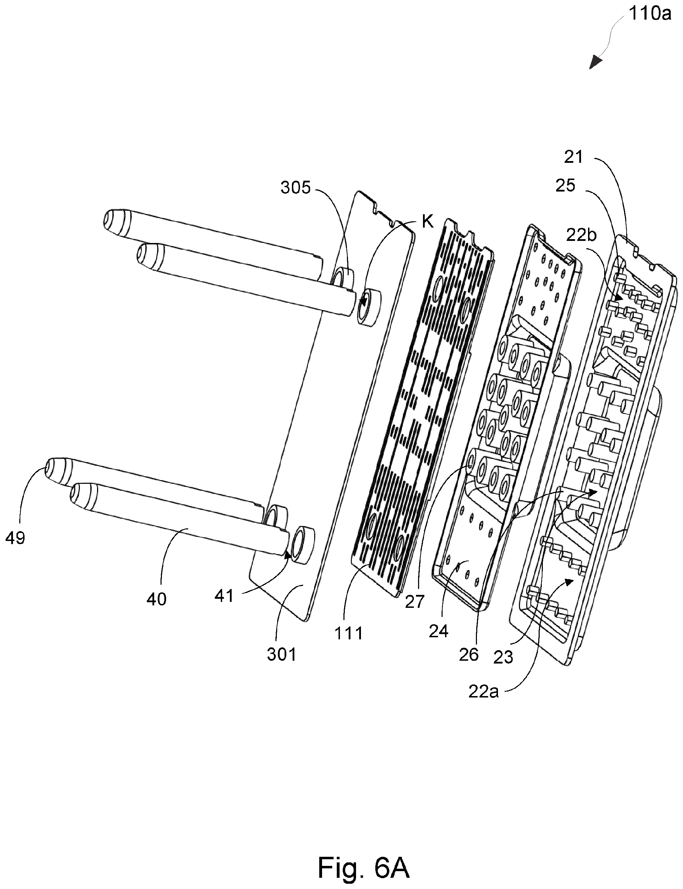

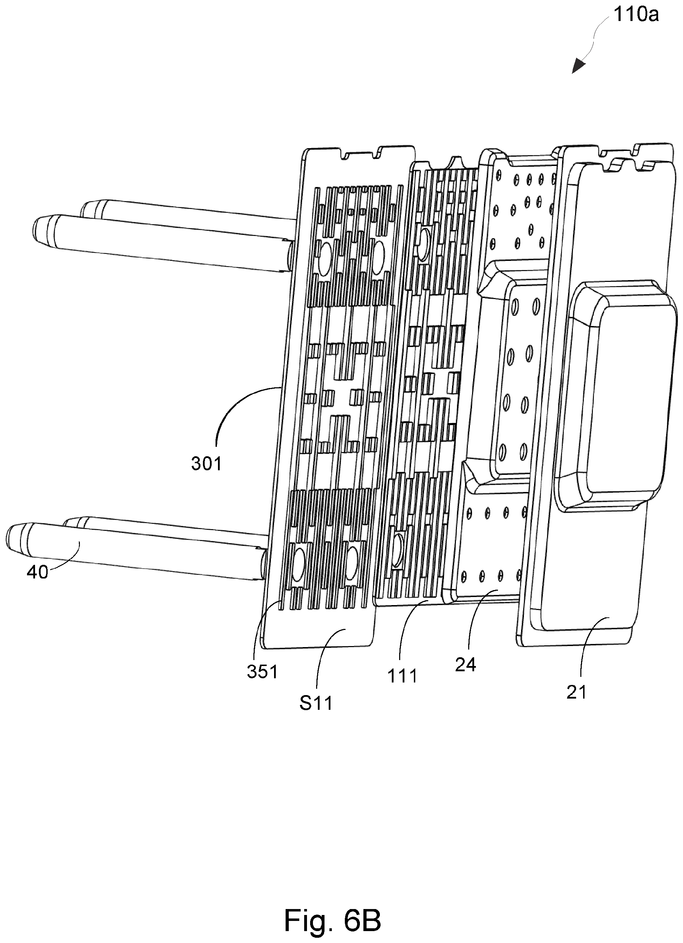

Fig. 5 includes at least an alternative embodiment of the vapor chamber 100 of Fig. 1 and Figs. 6A and 6B include at least another alternative embodiment of the vapor chamber 110 of Fig. 5. The another alternative vapor chamber 110a of Figs. 6A and 6B may be similar in some respects to the vapor chambers 100/110/100a of Figs. 1, 5, 2A, and 2B, and therefore may be best understood with reference thereto where like numerals designate like components not described again in detail. The difference between the alternative vapor chamber 110a of Figs. 6A and 6B and the vapor chambers 100/110/100a of Figs. 1, 5, 2A, and 2B is the second plate 301, the condenser wick structure 111, and the addition of the plurality of heat pipes 40. Each plurality of heat pipes 40 respectively includes an inner chamber surface (not shown), a closed end 49, an open end 41, and a pipe wick structure (not shown). The open end 41 is opposite the closed end 49 and the inner chamber surface is between the closed end 49 and the open end 41. The pipe wick structure is disposed on the inner chamber surface. The second plate 301 includes a plurality of through holes K. Each plurality of through holes K respectively includes a flange 305 and the flange 305 respectively extends from each plurality of through holes K opposite the second surface S11. Each plurality of heat pipes 40 abuts the flange 305 and each plurality of through holes K. The open end 41 respectively extends through each plurality of through holes K and abuts the evaporator wick structure 24. In some embodiments, the pipe wick structure is coupled to the evaporator wick structure 24 via metal bonding.

In some embodiments, the second plate 301 includes a plurality of condensate transport structures 351. The plurality of condensate transport structures 351 is coupled to and extends from the second surface S11. The condenser wick structure 111 is disposed on the plurality of condensate transport structures 351.

In some embodiments, each plurality of condensate transport structures 351 respectively includes a condensate structure length, and each plurality of condensate transport structures 351 respectively includes a cuboid shape. The condensate structure length includes two or more different lengths. In some embodiments, the plurality of condensate transport structures 351 is disposed along a length of the vapor chamber 100a from the third portion 22b, the first portion 23, and the second portion 22a, in rows. In some embodiments, more than one of each plurality of condensate transport structures 351 is disposed in one or more rows. In some embodiments, the condensate structure length includes one length.

In some embodiments, the plurality of first support structures 26, the first support wick portion 27, and the plurality of second support structures 25 respectively abut the condenser wick structure 111. In some embodiments, the plurality of condensate transport structures 351 is disposed in the first portion 23, in the second portion 22a, and in the third portion 22b. In some embodiments, a height of the plurality of condensate transport structures 35 disposed in the first portion 23 is greater than a height of the plurality of condensate transport structure disposed in the second portion 22a, and in the third portion 22b. In some embodiments, each plurality of condensate transport structures 35 includes one height.

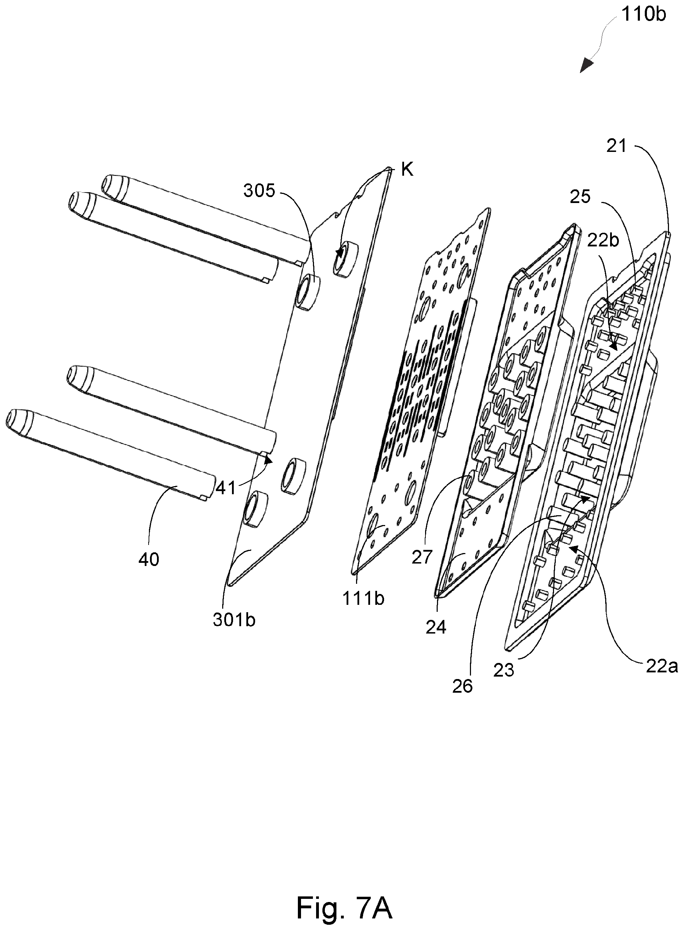

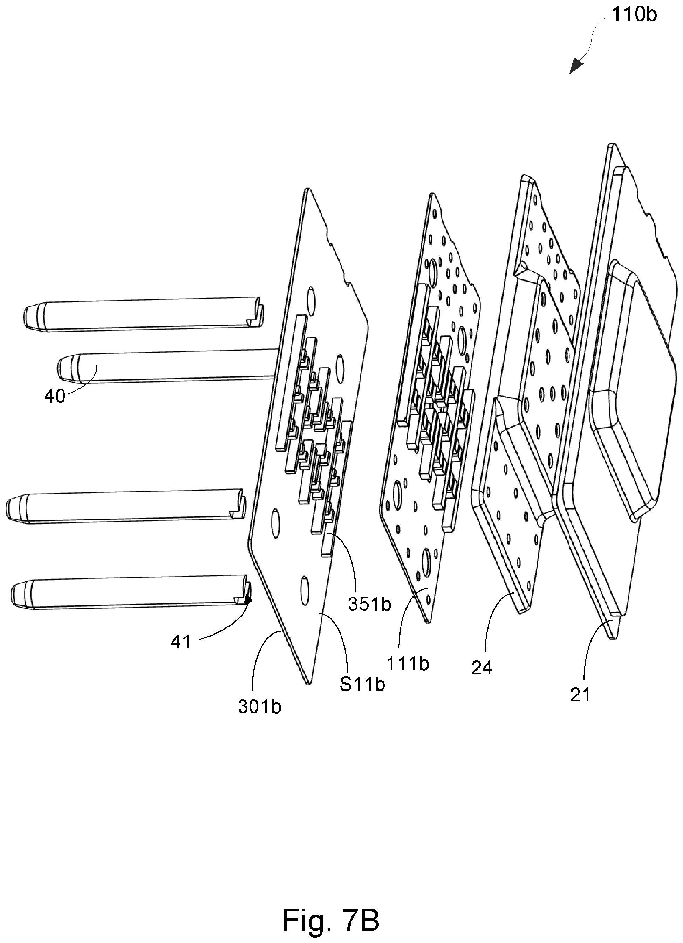

Figs. 7A and 7B include at least yet another alternative embodiment of the vapor chamber 110 of Fig. 5. The yet another alternative vapor chamber 110b of Figs. 7A and 7B may be similar in some respects to the vapor chambers 100/110/100b of Figs. 1, 5, 3A, and 3B, and therefore may be best understood with reference thereto where like numerals designate like components not described again in detail. The difference between the yet another alternative vapor chamber 110b of Figs. 7A and 7B and the vapor chambers 100/100b/100b of Figs. 1, 5, 3A, and 3B is the second plate 301b, the condenser wick structure 111b, and the condensate transport structures 351b. In some embodiments, the plurality of first support structures 26, the first support wick portion 27, and the plurality of second support structures 25 respectively abut the second surface S11b. The first support wick portion 27 abuts the condenser wick structure 111b. In some embodiments, the plurality of condensate transport structures 351b is disposed in the first portion 23.

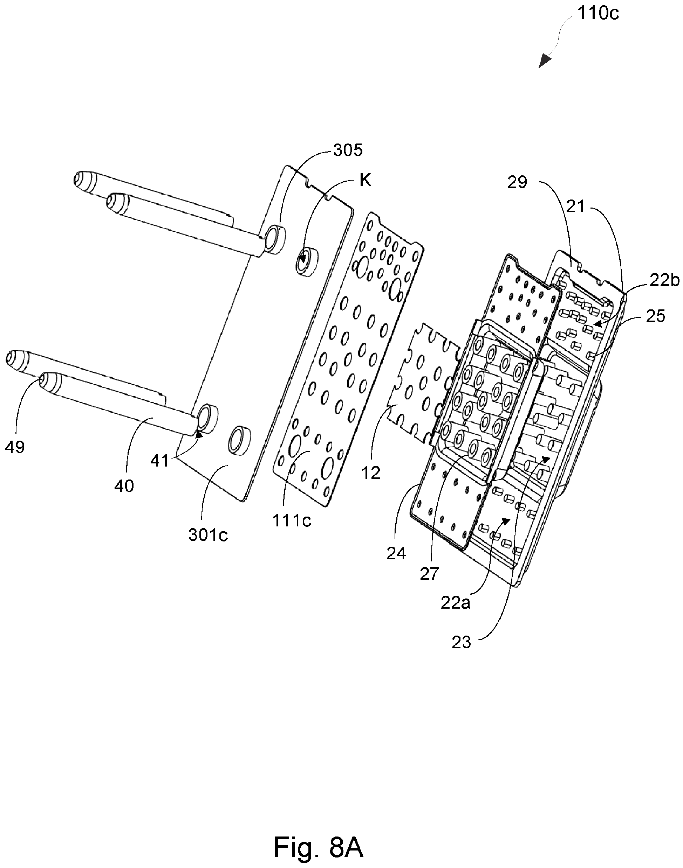

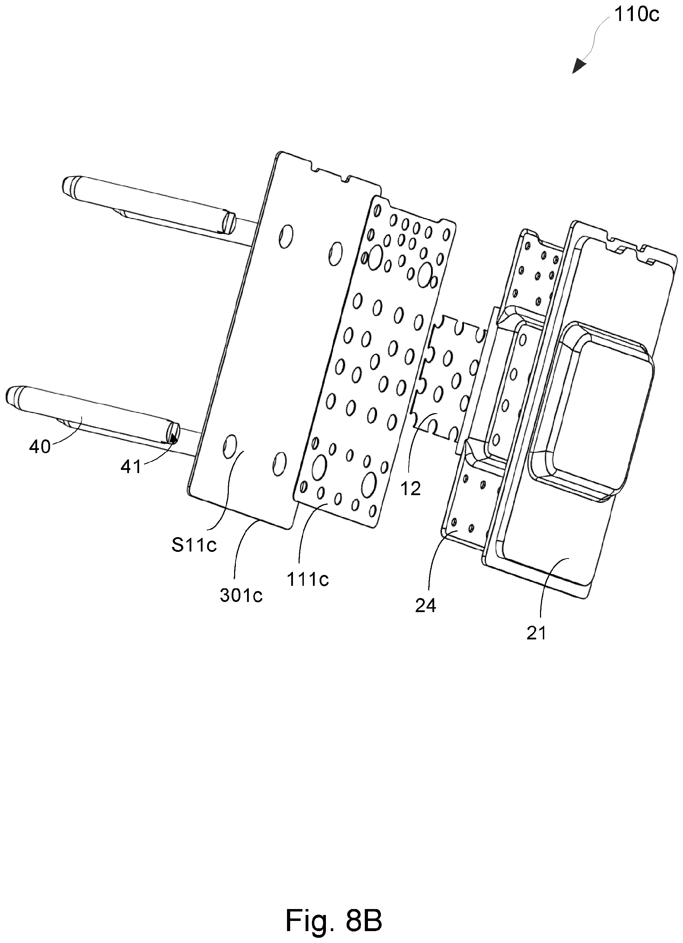

Figs. 8A and 8B include at least further yet another alternative embodiment of the vapor chamber 110 of Fig. 5. The further yet another alternative vapor chamber 110c of Figs. 8A and 8B may be similar in some respects to the vapor chambers 100/110/100c of Figs. 1, 5, 4A, and 4B, and therefore may be best understood with reference thereto where like numerals designate like components not described again in detail. The difference between the further yet another alternative 110c of Figs. 4A and 4B and the vapor chambers 100/110/100c of Figs. 1, 5, 4A, and 4B is the second plate 301c, the condenser wick structure 111c, the elimination of the condensate transport structures 351, and the addition of the core condenser wick structure 12. The core condenser wick structure 12 is coupled to and extends from the condenser wick structure 111c. The core condenser wick structure 12 is disposed in the first portion 23. In some embodiments, the plurality of first support structures 26 and the plurality of second support structures 25 respectively abut the second surface S11c, and the first support wick portion 27 abuts the core condenser wick structure 12. In some embodiments, the core condenser wick structure 12 includes at least one of a sintered metal powder wick, a metal mesh wick, and a sintered ceramic powder wick.

The vapor chambers 100/100a/100b/100c/110/110a/110b/110c of the present disclosure increase surface area, thereby increasing working fluid pathways to increase heat dissipation efficiency. The condenser wick structures 11/11b/11c/111/111b/111c speeds up transport of condensed working fluid back to the first surface 28 opposite the heat source. Moreover, the plurality of condensate transport structures 35/35b//351/351b further enhances transport of the condensed working fluid. Furthermore, the plurality of heat pipes 40 increases surface area within the second portion 22a and the third portion 22b, even further increasing condensation surfaces, improving thermal performance of the vapor chambers 110/110a/110b/110c. Yet even furthermore, the core condenser wick structure 12 extends from the condenser wick structures 11c/111c in the first portion 23, abutting the first support wick portion 27, to even further accelerate transport of the condensed working fluid. Also, the first surface wick portion 24 and the first support wick portion 27 of the evaporator wick structure 24 and 27 further enhances transport of condensed working fluid back to the first surface 28, with the first support wick portion 27 coupled to the condenser wick structures 11/11b/111//111b or the core condenser wick structure 12. Moreover, the capillary pumping action of the third amount of the plurality of second support structures 25 disposed in the third portion 22b being greater than the second amount of the plurality of second support structures 25 disposed in the second portion 22a, driving vapor to flow from the first portion 23 and the second portion 22a for condensation, and working fluid to flow from the second surface S1/S1b/S1c/ S11/S11b/S11c and condenser wick structure 11/11b/111/111b or core condenser wick structure 12 to the first support wick portion 27 and the evaporator wick structure 24 and the third portion 22b back to the first surface 28 and first portion 23, adds to the effectiveness of the vapor chambers 100/100a/100b/100c/110/110a/110b/110c to dissipate heat via the phase change (liquid-vapor-liquid) mechanism, increasing the thermal performance of the vapor chambers 100/100a/100b/100c/110/110a/110b/110c. Thus, overheating of electronic components of thin and compact electronic device, as the generated heat of the electronic component is more efficiently distributed along the vapor chamber to adequately cool the electronic component, and prevent overheating of the electronic components.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean than one of the element that it introduces.

## Claims

1. A vapor chamber (100c, 110c), comprising:
a first plate (21), the first plate (21) including a first surface (28), a first plate perimeter ledge (29), a plurality of first support structures (26), and a plurality of second support structures (25), the plurality of first support structures (26) and the plurality of second support structures (25), both, respectively coupled to and extending from the first surface (28), the first plate perimeter ledge (29) surrounding the first surface (28);
an evaporator wick structure (24, 27), the evaporator wick structure (24, 27) including a first surface wick portion (24) and a first support wick portion (27), the first surface wick portion (24) disposed on the first surface (28) and the first support wick portion (27) disposed on the plurality of first support structures (26);
a second plate (30c, 301c), the second plate (30c, 301c) including a second surface (S1c, S11c) and a second plate perimeter portion (39), the second plate perimeter portion (39) surrounding the second surface (S1c, S11c), the second plate perimeter portion (39) coupled to the first plate perimeter ledge (29); wherein the first plate (21) and the second plate (30c, 301c) define an interior cavity, the interior cavity includes a first portion (23), a second portion (22a), and a third portion (22b);
a condenser wick structure (11c, 111c), the condenser wick structure (11c, 111c) disposed on the second surface (S1c, S11c), and
a core condenser wick structure (12), the core condenser wick structure (12) coupled to and extending from the condenser wick structure (11c, 111c), the core condenser wick structure (12) disposed in the first portion (23).

2. The vapor chamber (100c, 110c) of claim 1, wherein the plurality of first support structures (26) and the plurality of second support structures (25) respectively abut the second surface (S1c, S11c), and wherein the first support wick portion (27) abuts the core condenser wick structure (12).

3. The vapor chamber (100c, 110c) of claim 1 or 2, wherein the first portion (23) includes a first depth (FD), second perimeter edge (221a) and a third perimeter edge (221b), the second portion (22a) includes a second depth (SD), and the third portion (22b) includes a third depth (TD), the third perimeter edge (221b) opposite the second perimeter edge (221a), the second portion (22a) extending in a second direction from the second perimeter edge (221a) and the third portion (22b) extending in a third direction from the third perimeter edge (221b), the first depth (FD) and the second depth (SD) and the third depth (TD), all, extend from the first surface (28) to the second surface (S1c, S11c), the second depth (SD) equal to the third depth (TD), the first depth (FD) greater than the second depth(SD) and the third depth (TD).

4. The vapor chamber (100c, 110c) of claim 3, wherein each plurality of first support structures (26) respectively includes a first diameter (FDi), and wherein each plurality of second support structures (25) respectively includes a second diameter (SDi), the first diameter (FDi) greater than the second diameter (SDi), and the plurality of first support structures (26) is disposed in the first portion (23) and the plurality of second support structures (25) is disposed in the second portion (22a) and the third portion (22b).

5. The vapor chamber (100c, 110c) of claim 4, wherein the plurality of second support structures (25) disposed in the second portion (22a) include a second amount, and wherein the plurality of second support structures (25) disposed in the third portion (22b) include a third amount, the third amount greater than the second amount.

6. The vapor chamber (100c, 110c) of any one of claims 1 to 5, wherein the core condenser wick structure (12) includes at least one of a sintered metal powder wick, a metal mesh wick, and a sintered ceramic powder wick.

7. The vapor chamber (100c, 110c) of any one of claims 1 to 6, wherein the condenser wick structure (11c, 111c) includes at least one of a sintered metal powder wick, a metal mesh wick, and a sintered ceramic powder wick.

8. The vapor chamber (100c, 110c) of any one of claims 1 to 7, wherein the evaporator wick structure (24, 27) includes at least one of a sintered metal powder wick, a metal mesh wick, and a sintered ceramic powder wick.

9. The vapor chamber (110c) of any one of claims 1 to 8, comprising a plurality of heat pipes (40), each plurality of heat pipes (40) respectively includes an inner chamber surface, a closed end (49), an open end (41), and a pipe wick structure, the open end (41) opposite the closed end (49), the inner chamber surface between the closed end (49) and the open end (41), the pipe wick structure disposed on the inner chamber surface, and wherein the second plate (301C) includes a plurality of through holes (K), each plurality of through holes (K) respectively includes a flange (305), the flange (305) respectively extending from each plurality of through holes (K) opposite the second surface (S11c), each plurality of heat pipes (40) abuts the flange (305) and each plurality of through holes (K), the open end (41) respectively extends through each plurality of through holes (K) and abuts the evaporator wick structure (24, 27).
